(19) 

Europäisches
Patentamt

European
Patent Office

Office européen
des brevets

(11) **EP 3 015 826 B1**

(12) **EUROPÄISCHE PATENTSCHRIFT**

(45) Veröffentlichungstag und Bekanntmachung des Hinweises auf die Patenterteilung:
**20.09.2017 Patentblatt 2017/38**

(51) Int Cl.:
*G01D 5/20* *(2006.01)*   *H03K 17/95* *(2006.01)*

(21) Anmeldenummer: **14190723.8**

(22) Anmeldetag: **28.10.2014**

(54) **Sensorvorrichtung, Bedienwerkzeug und Verfahren zum Bedienen selbiger**

Sensor device, operating tool and method for operating the same

Dispositif de capteur, outil de commande et son procédé d'utilisation

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**04.05.2016 Patentblatt 2016/18**

(73) Patentinhaber: **BAUMER ELECTRIC AG**
**8500 Frauenfeld (CH)**

(72) Erfinder:
• **Jürgens, Alexander**
**8500 Frauenfeld (CH)**

• **Wehrle, Wolfgang**
**78467 Konstanz (DE)**
• **Clad, Marius**
**8280 Kreuzlingen (CH)**

(74) Vertreter: **Strauss, Steffen**
**Baumer Innotec AG**
**Hummelstrasse 17**
**Group Intellectual Property**
**8501 Frauenfeld (CH)**

(56) Entgegenhaltungen:
DE-A1-102006 032 226   DE-A1-102007 054 604
DE-A1-102008 010 864   DE-B- 1 175 327

EP 3 015 826 B1

**Beschreibung**

Die vorliegende Erfindung betrifft eine Sensorvorrichtung, insbesondere optische Sensorvorrichtung zur Objektwahrnehmung, mit einer elektrischen Schaltung, die wenigstens einen elektrischen Schwingkreis und eine Auswerteeinheit umfasst, die ausgestaltet ist, einen Ausgangszustand und einen gedämpften Zustand des Schwingkreises zu unterscheiden, wobei dem Wechsel zwischen Ausgangszustand und gedämpften Zustand ein Wechsel einer Betriebsart der Sensorvorrichtung zugeordnet ist.

Ferner betrifft die Erfindung eine Anordnung umfassend eine Sensorvorrichtung und ein Bedienwerkzeug.

Schließlich betrifft die Erfindung ein Verfahren zum Bedienen einer Sensorvorrichtung, insbesondere zum Zwecke der Objektwahrnehmung, wobei ein elektrischer Schwingkreis einer Schaltung der Sensorvorrichtung von einem Ausgangszustand in einen gedämpften Zustand überführt wird, wobei mit einer Auswerteeinheit der Schaltung der Ausgangszustand vom gedämpften Zustand unterschieden wird, und wobei bei einem Wechsel zwischen Ausgangszustand und gedämpften Zustand eine Betriebsart der Sensorvorrichtung geändert wird.

Sensorvorrichtungen, Bedienwerkzeuge, diese umfassende Anordnungen und Verfahren der vorgenannten Art sind aus dem Stand der Technik bekannt. So kann beispielsweise mittels eines Oszillators der Sensorvorrichtung ein elektromagnetisches Wechselfeld erzeugt werden, das aus einem Gehäuse der Sensorvorrichtung austritt. Mit einem Bedienwerkzeug, beispielsweise einem metallischen Gegenstand, wie einer Schraubenzieherspitze, kann das Magnetfeld geändert und somit Wirbelströme in leitenden Materialien hervorgerufen werden. Diese Wirbelströme erzeugen ihrerseits ein Magnetfeld, das gemäß der Lenzschen Regel der Änderung des äußeren Magnetfeldes entgegenwirkt. Daraus resultiert eine Reduzierung bzw. Dämpfung der Änderung der magnetischen Flussdichte $\Delta B$, welche durch die Änderung der magnetischen Feldstärke $\Delta H$ der Spule hervorgerufen wird. Diese Dämpfung ist beispielsweise durch einen reduzierten Spannungsabfall über die Spule des Schwingkreises messbar. Somit können berührungslos durch Annäherung des Bedienwerkzeuges an die Sensorvorrichtung deren Betriebsarten geändert bzw. umgeschaltet werden. Beispielsweise kann dies zum Einlernen, sogenanntem Teachen, der Sensorvorrichtung verwendet werden.

Die Druckschrift DE 11 753 27 B betrifft einen elektrischen Annäherungsschalter unter Verwendung eines Schwingungskreises.

Die Druckschrift DE 10 2006 032 226 A1 betrifft ein Verfahren zum Überwachen eines Abstands eines metallischen Teils relativ zu einem induktiven Näherungssensor.

Ein Nachteil bei den bekannten Vorrichtungen, Bedienwerkzeugen, Anordnungen und Verfahren besteht darin, dass der Bedienumfang und -komfort eingeschränkt ist. So kann mittels des Bedienwerkzeuges jeweils nur ein einziger Betriebsartwechsel vorgenommen werden. Der vorliegenden Erfindung liegt in Anbetracht dieser Nachteile die Aufgabe zugrunde, insbesondere ohne Verwendung zusätzlicher mechanischer Teile den Bedienumfang zu erweitern bzw. den Bedienkomfort zu verbessern.

Diese Aufgabe wird für eine eingangs genannte Sensorvorrichtung erfindungsgemäß dadurch gelöst, dass die Auswerteeinheit ausgestaltet ist, einen weiteren gedämpften Zustand vom gedämpften Zustand zu unterscheiden, wobei den Wechsel zum weiteren gedämpften Zustand eine weitere Betriebsart der Sensorvorrichtung zugeordnet ist.

Für eine eingangs genannte Anordnung wird die Aufgabe erfindungsgemäß dadurch gelöst, dass sie eine erfindungsgemässe Sensorvorrichtung und ein Bedienwerkzeug umfasst, wobei das Bedienwerkzeug einen ersten Bedienabschnitt und wenigstens einen weiteren Bedienabschnitt aufweist, wobei sich die magnetischen Eigenschaften der Bedienabschnitte voneinander unterscheiden.

Bei einem eingangs genannten Verfahren wird die Aufgabe erfindungsgemäß dadurch gelöst, dass der Schwingkreis in einen weiteren gedämpften Zustand gebracht wird, dass mit der Auswerteeinheit der weitere gedämpfte Zustand vom gedämpften Zustand unterschieden wird, und dass beim Wechsel vom und/oder zum weiteren gedämpften Zustand die Betriebsart der Sensorvorrichtung geändert wird.

Diese Lösungen haben den Vorteil, dass von der Betriebsart im Ausgangszustand aus mindestens zwei weitere Betriebsarten durch einen Bedienvorgang erreicht werden können. So kann beispielsweise durch den Wechsel vom Ausgangszustand zum gedämpften Zustand die Sensorvorrichtung von einem Betriebsmodus in einen Einlernmodus überführt werden. Als weitere Betriebsart kann die Sensorvorrichtung im eingelernten Zustand verriegelt werden, so dass nicht versehentlich das eingelernte Verhalten der Sensorvorrichtung verloren geht. Auch ist denkbar, verschiedene Sensoren der Sensorvorrichtung durch Wahl verschiedener Betriebsarten anzusprechen bzw. in einen Einlernmodus zu versetzen. Alternativ oder zusätzlich können verschiedene Menüebenen in den verschiedenen Betriebsarten implementiert sein, wie beispielsweise dass der einen Betriebsart eine Bedienung innerhalb einer Menüebene zugeordnet ist und der weiteren Betriebsart ein Wechsel bzw. eine Auswahl von Menüebenen.

Die Anzahl der weiteren gedämpften Zustände kann den jeweiligen Anforderungen gemäß gewählt werden. So können verschiedenen Dämpfungswerten bzw. Messspannungen verschiedene Umschaltpunkte beispielsweise als Schwellwerte zugeordnet werden. Diese Schwellwerte können verschiedenen Bedienabschnitten des Bedienwerkzeuges zugeordnet sein. Insbesondere beim Einsatz der erfindungsgemäßen Lösungen zum Einlernen einer Sensorvorrichtung können Schaltung und Auswerteeinheit Teil einer Einlerneinrichtung der Sensorvorrichtung sein. Die Auswerteeinheit kann zum Erfassen einer an einer Spule des Schwingkreises anliegenden effektiven elektrischen Spannung ausgestaltet sein. Dem Ausgangszustand, gedämpften Zustand und wenigstens einem weiteren gedämpften Zustand kann jeweils eine Betriebsart der Sensorvorrichtung zugeordnet sein. Die Schaltung kann sich in einem gedämpften Zustand in einem ersten Modus und im weiteren gedämpften Zustand in einem weiteren Modus befinden. Der Ausgangszustand kann ein ungedämpfter Zustand sein.

Hinsichtlich der eingangs genannten Sensorvorrichtung kann die erfindungsgemäße Lösung mit den folgenden weiteren, jeweils für sich vorteilhaften Ausführungsformen beliebig ergänzt und weiter verbessert werden.

So kann gemäß einer ersten vorteilhaften Ausführungsform einer erfindungsgemäßen Sensorvorrichtung vorgesehen sein, dass ein Spulenkern einer elektrischen Spule des Schwingkreises sich im weiteren gedämpften Zustand in magnetischer Sättigung befindet. So kann die im Schwingkreis verwendete Spule mit einem Spulenkern ausgestattet sein, welcher mit Hilfe eines beliebig starken magnetischen Bedienwerkzeugs in Sättigung gebracht werden kann. Dadurch sinkt die Induktivität der Spule deutlich ab und der Schwingkreis wird stärker als mit weniger stark magnetischen, beispielsweise lediglich ferromagnetischen bzw. metallischen Bedienwerkzeugen bedämpft. Im Gegensatz zur alleinigen Dämpfung mittels Metall funktioniert die Bedämpfung durch ein magnetisches Bedienwerkzeug für relativ große Abstände von der Sensorvorrichtung bzw. deren Schaltung und sogar durch Metall hindurch. Insbesondere bei gleichem Abstand zwischen Bedienwerkzeug und Sensorvorrichtung bzw. deren Schaltung sind die Dämpfungsunterschiede der verschieden magnetischen Materialien so groß wählbar, dass diese einfach voneinander unterschieden und entsprechenden Betriebszuständen bzw. Wechseln zwischen Betriebszuständen zugeordnet werden können.

Die Sensorvorrichtung kann eine mit einem Bedienwerkzeug zugängliche Schalt- bzw. Bedienzone aufweisen, wobei der Schwingkreis zumindest abschnittsweise lageveränderlich zur Schaltzone ausgestaltet sein kann. Somit kann die Lage des vom Bedienwerkzeug ausgehenden Magnetfeldes bezüglich der Spule den jeweiligen Anforderungen gemäß eingestellt werden. Dieser Effekt kann beispielsweise dadurch genutzt werden, indem mittels eines Schraubenziehers, Schiebers oder Drehknopfes die Position bzw. Orientierung eines Werkzeugs bzw. der elektrischen Spule eingestellt wird. Diese Funktionalität wäre mit der Funktion eines Potentiometers zum Regulieren der magnetischen Wechselwirkungen zwischen Schaltung und Bedienwerkzeug vergleichbar.

Die Sensorvorrichtung kann sich in wenigstens einer Betriebsart in einem Empfangsmodus zum Empfangen eines Datenstroms befinden. So kann beispielsweise mittels einer elektrischen Sendespule von außen ein variables Magnetfeld an die Schaltung bzw. deren Spule angelegt werden. Mit Hilfe dieser Sendespule können digitale Parameter, wie zum Beispiel maximale Tastweiten, Einschalt-, Ausschaltverzögerungen und/oder sonstige Einstellmöglichkeiten an die Sensorvorrichtung übergeben werden. Die Schaltung kann zum Empfangen eines Datenstromes durch Bedämpfungsänderungen des Schwingkreises ausgestaltet sein. Die Schaltung kann mit einer Datenspeichereinrichtung verbunden sein. Die Datenspeichereinrichtung kann Teil der Auswerteeinheit sein und insbesondere dazu dienen, auf die Schaltung übertragende Datenströme in der Sensorvorrichtung zu speichern. Neben digitalen Datenströmen ist es auch möglich, analoge Signalverläufe mit Hilfe der Schaltung zu registrieren und zur Parametrierung der Sensorvorrichtung im Datenspeicher zu hinterlegen.

Für die eingangs genannte Anordnung kann die erfindungsgemäße Lösung beispielsweise dadurch beliebig ergänzt und verbessert werden, dass der erste Bedienabschnitt des Bedienwerkzeuges ferromagnetisch und der wenigstens eine weitere Bedienabschnitt permanent- und/oder elektromagnetisch aktivierbar ausgestaltet ist. So kann beispielsweise durch Bewegung eines Permanentmagneten im Bedienwerkzeug die magnetische Eigenschaft des Bedienabschnitts verändert werden. Bei Verwendung eines elektromagnetischen Bedienabschnitts kann dieser beispielsweise durch einen Schalter am Bedienwerkzeug aktiviert werden. Mit Hilfe des elektromagnetischen Bedienabschnitts kann darüber hinaus ein Datenstrom zur Sensorvorrichtung übertragen werden.

Die erfindungsgemäße Lösung beim eingangs genannten Verfahren kann gemäß einem ersten weiteren möglichen Verfahrensschritt dadurch verbessert werden, dass zum Wechsel der Betriebsart jeweils ein Umschaltpunkt in einer Dämpfungskurve des Schwingkreises über- und/oder unterschritten wird. So kann mit jeder Überschreitung eines Umschaltpunktes bzw. einer Schwelle der Dämpfung oder der diese repräsentierenden elektrischen Spannung über der Spule ein Wechsel der Betriebsart ausgelöst werden. Alternativ oder zusätzlich ist es möglich, dass beispielsweise beim einmaligen Über- oder Unterschreiten zunächst ein Wechsel der Betriebsart stattfindet, wobei diese Betriebsart dann bis zur nächsten Über- bzw. Unterschreitung aufrechterhalten wird.

Wie schon oben bezüglich der Vorrichtung erwähnt, kann vorgesehen sein, dass ein Spulenkern einer elektrischen Spule des Schwingkreises zur Erreichung des weiteren gedämpften Zustands in magnetische Sättigung gebracht wird. Ein Umschaltpunkt zum Wechseln von Betriebsarten kann beim Erreichen der Sättigung erreicht bzw. überschritten sein. Das Nutzen der magnetischen Sättigung hat den Vorteil, dass die Zunahme des äußeren Magnetfeldes keinen weiteren Spannungsabfall über der Spule zur Folge hat und somit ein definiertes Maximum bzw. Minimum gegeben ist.

Durch den Wechsel zwischen Ausgangszustand und gedämpften Zustand, zwischen Ausgangszustand und weiterem gedämpften Zustand und/oder gedämpften und weiterem gedämpften Zustand kann die Sensorvorrichtung in einen Empfangsmodus zum Empfangen eines Datenstromes versetzt werden. Auch ist es möglich, durch eine beliebige Kombination von Wechseln der Zustände den Empfangsmodus zu aktivieren. Im Empfangsmodus ist es möglich, dass über den Schwingkreis ein Datenstrom auf die und/oder von der Sensorvorrichtung übertragen wird.

Die Sensorvorrichtung kann mit einem erfindungsgemäßen Bedienwerkzeug bedient werden. Das Bedienwerkzeug kann den jeweiligen Anforderungen gemäß ausgestaltet sein, um mit der Sensorvorrichtung zusammenzuwirken. Sensorvorrichtung bzw. deren Schaltung und Bedienwerkzeug können in ihren magnetischen Eigenschaften den jeweiligen Anforderungen gemäß aufeinander abgestimmt sein, um beispielsweise durch Annäherung des Bedienwerkzeuges an die Sensorvorrichtung, Entfernung des Bedienwerkzeuges von der Sensorvorrichtung, Berührung der Sensorvorrichtung mit dem Bedienwerkzeug und/oder Verweilen des Bedienwerkzeuges in einer vorbestimmten Position relativ zur Sensorvorrichtung diese zu bedienen.

Im Folgenden wird die Erfindung anhand vorteilhafter Ausführungsformen mit Bezug auf die Zeichnungen beispielhaft näher erläutert. Die beschriebenen Ausführungsformen stellen dabei lediglich mögliche Ausgestaltungen dar, bei denen jedoch die einzelnen Merkmale, wie oben beschrieben ist, unabhängig voneinander realisiert und weggelassen werden können. In den Erläuterungen werden gleiche Elemente der Erfindung durchgehend mit gleichen Bezugszeichen benannt, um unnötig wiederholte Beschreibungen zu vermeiden.

Es zeigen:

Fig. 1 eine erste Ausführungsform einer erfindungsgemäßen Anordnung umfassend eine Sensorvorrichtung und ein Bedienwerkzeug;

Fig. 2 eine zweite Ausführungsform einer erfindungsgemäßen Anordnung umfassend eine Sensorvorrichtung und ein Bedienwerkzeug; und

Fig. 3 eine exemplarische Schar von Hysterese- bzw. Dämpfungskurven für unterschiedliche Feldstärken eines magnetischen Feldes einer in einer erfindungsgemäßen Sensorvorrichtung eingesetzten Spule.

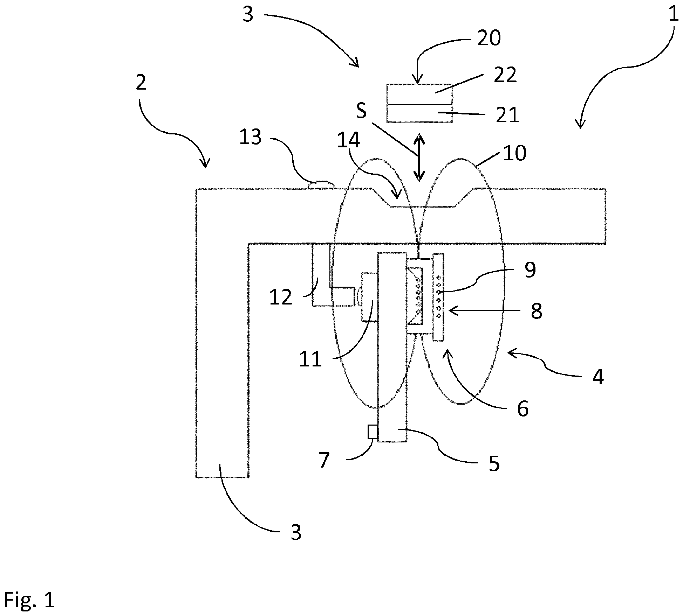

Zunächst wird eine erfindungsgemäße Anordnung 1 unter Bezug auf Fig. 1 beschrieben, welche die Anordnung 1 in einer schematischen teilgeschnitten Seitenansicht zeigt. Die Anordnung 1 umfasst eine Sensorvorrichtung 2, die beispielsweise ein Gehäuse 3 besitzen kann, in dem eine Schaltung 4 angeordnet ist. Die Schaltung 4 kann eine Leiterplatte 5 umfassen, die einen elektrischen Schwingkreis 6, und eine Auswerteeinheit 7 tragen kann. Der Schwingkreis 6 kann eine Spule 8 mit einem Spulenkern 9 umfassen, die gemeinsam ein elektromagnetisches Feld 10 erzeugen.

Ein Signalgeber 11, beispielsweise eine lichtemittierende Diode (LED), kann energie- und/oder datenübertragend mit der Schaltung 4 verbunden sein. Vom Signalgeber 11 ausgehende Signale, beispielsweise Lichtsignale, können mit Hilfe eines Leiters 12, beispielsweise eines Lichtleiters, zu einem außerhalb des Gehäuses 3 angeordneten Anzeigeelements 13 übertragen werden, um beliebige Zustände bzw. Betriebsarten anzuzeigen. Außerhalb des Gehäuses 3 kann eine Bedien- bzw. Schaltzone 14, beispielsweise in Form einer Vertiefung ausgeformt sein, die eine Orientierungshilfe bei der Bedienung der Sensorvorrichtung 2 bieten kann.

Des Weiteren umfasst die Anordnung 1 ein Bedienwerkzeug 20, das einen ersten Bedienabschnitt 21 und einen weiteren Bedienabschnitt 22 aufweist. Das Bedienwerkzeug 20 kann entlang eine Bedienrichtung S auf die Sensorvorrichtung 2 zu und von dieser weg bewegt werden. Der erste Bedienabschnitt 21 und der weitere Bedienabschnitt 22 weisen unterschiedliche magnetische Eigenschaften auf. Beispielsweise kann der erste Bedienabschnitt 21 ferromagnetisch und der weitere Bedienabschnitt 22 permanentmagnetisch und/oder elektromagnetisch ausgestaltet sein. Auch ist es denkbar, den ersten Bedienabschnitt 21 in seiner Lage relativ zum zweiten Bedienabschnitt 22 veränderlich auszugestalten.

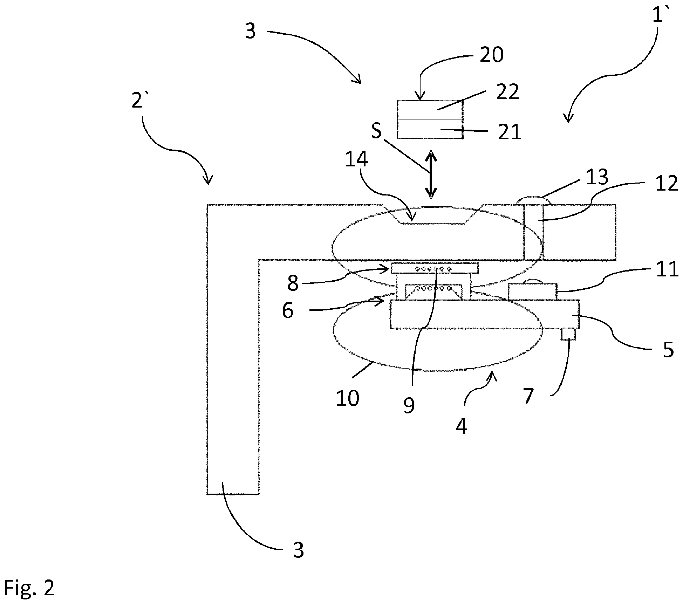

Fig. 2 zeigt eine weitere Ausführungsform einer erfindungsgemäßen Anordnung 1' mit einer weiteren Ausführungsform einer erfindungsgemäßen Sensorrichtung 2' in einer schematischen, teilgeschnittenen Seitenansicht analog zu Fig. 1. Im Unterschied zu der in Fig. 1 gezeigten Anordnung 1 ist de Schwingkreis 6 der Sensorvorrichtung 2' anders bezüglich des Gehäuses 3 bzw. der Schaltzone 14 ausgerichtet. Beispielsweise kann dazu der Schwingkreis 6 um 90° gedreht worden sein, so dass Spule 8 mit Spulenkern 9 und somit das elektromagnetische Feld 10 anders als in Fig. 1 ausgerichtet ist. Im Vergleich zum in Fig. 1 gezeigten magnetischen Feld 10 kann das in Fig. 2 gezeigte magnetische Feld 10 beispielsweise weniger stark in Bedienrichtung S in Richtung zur Schaltzone 14 hin ausgeprägt sein, wodurch die Empfindlichkeit der Schaltung 4 in Fig. 2 gegenüber der Empfindlichkeit der Schaltung 4 in Fig. 1 herabgesetzt sein kann. Somit stellt die unterschiedliche Ausrichtung des elektromagnetischen Feldes in Fig. 1 und 2 eine Möglichkeit zur Regulierung der Empfindlichkeit der Sensorvorrichtung 2 bzw. 2' bei der Bedienung mit dem Bedienwerkzeug dar.

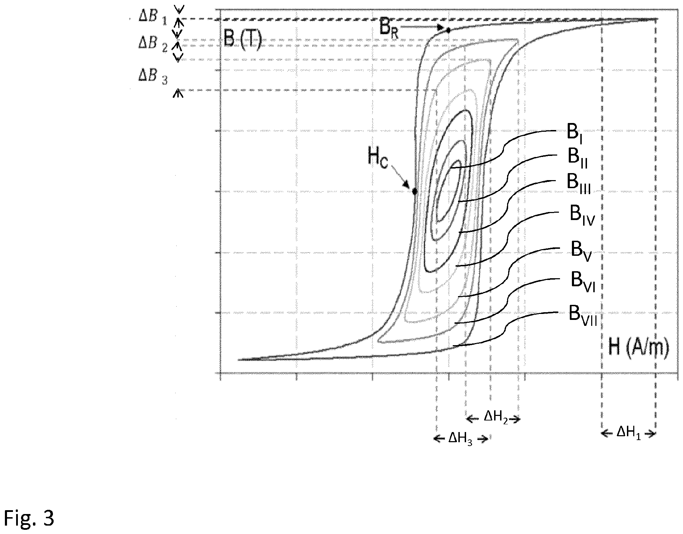

Fig. 3 zeigt exemplarisch eine Schar von Hysteresekurven magnetischer Flussdichte B für unterschiedliche magnetische Feldstärken H bei verschieden starken Magnetfeldern $B_I$ bis $B_{VII}$ des Bedienwerkzeugs 20. Es ist klar zu erkennen, dass die Permeabilität $\mu$ als Verhältnis der Änderung der magnetischen Flussdichte $dB$ zur Änderung der magnetischen Feldstärke $dH$ nicht konstant ist, sondern von den magnetischen Feldstärken H und der Magnetisierungsvorgeschichte des Spulenkerns 9 abhängt. So ergibt sich die Permeabilität aus (Formel 1)

$$\mu = \frac{dB}{dH}.$$

Die verbleibende Magnetisierung des Materials nach Wegfall des äußeren vom Bedienwerkzeug 20 ausgeübten Magnetfeldes ist das Remanenzmagnetfeld $B_R$. Die magnetische Feldstärke, die notwendig ist, um die ferromagnetische Substanz wieder vollständig zu entmagnetisieren ist als magnetische Koerzitivfeldstärke $H_C$ bezeichnet. Dieser Effekt wird erfindungsgemäß genutzt, indem in die Spule 8 ein Strom eingespeist und die effektive Spannung über die Spule 8 gemessen wird. Für die über eine Zylinderspule abfallende Spannung $u(t)$ gilt folgende Näherungsformel (Formel 2):

$$u(t) = \mu \cdot \frac{n^2}{l} \cdot A \frac{di}{dt},$$

wobei $l$ die Länge der Spule 8, $n$ = deren Windungszahl, $A$ = deren Querschnittsfläche und $i$ = der elektrische Strom ist.

Aus den Formen 1 und 2 ergibt sich ein Proportionalitätszusammenhang zwischen Spannung und Permeabilität wie folgt (Formel 3):

$$u(t) \sim \mu \qquad => \qquad u(t) \sim \frac{dB}{dH}.$$

Da die in dem Schwingkreis 6 eingebrachte Stromstärke vorgegeben ist, ergibt sich eine feste Änderung der magnetischen Feldstärke $\Delta H$ wie folgt (Formel 4):

$$\Delta H = 2 \cdot \frac{I \cdot N}{\sqrt{l^2 + D^2}},$$

wobei $I$ = die Stromstärke und $N$ = die Windungszahl, $l$ = die Länge und $D$ = der Durchmesser der Spule ist.

Folglich wird erfindungsgemäß eine Änderung der magnetischen Flussdichte $\Delta B$ in Folge einer vorgegebenen Änderung der magnetischen Feldstärke $\Delta H$ gemessen. So rufen Änderungen des äußeren Magnetfelds 10 durch einen lediglich elektrisch leitenden bzw. ferromagnetischen ersten Bedienabschnitt 21 des Bedienwerkzeugs 20 Wirbelströme hervor. Diese Wirbelströme erzeugen ihrerseits ein Magnetfeld im Bedienabschnitt 21, das gemäß der Lenzschen Regel der Änderung des magnetischen Feldes 10 entgegenwirkt. Als Resultat wird die Änderung der Magnetischen Flussdichte $\Delta B$, welche durch die Änderung der magnetischen Feldstärke $\Delta H$ in der Spule 8 hervorgerufen wird, reduziert bzw. gedämpft. Diese Dämpfung ist durch den reduzierten Spannungsabfall über die Spule 8 messbar.

Im Falle der Verwendung eines permanent- und/oder elektromagnetischen weiteren Bedienabschnitts 22 des Bedienwerkzeugs 20 überlagert sich eine durch den weiteren Bedienabschnitt 22 hervorgerufene konstante magnetische Feldstärke $H_{magnet}$ mit einer durch die Spule hervorgerufene Änderung der magnetischen Feldstärke $\Delta H_{Spule}$, da die Permeabilität $\mu$ des Ferritkerns nicht konstant ist, sondern mit zunehmender Feldstärke abnimmt. Eine gleiche Änderung der Feldstärke ruft dadurch deutlich geringere Änderungen der magnetischen Flussdichte $\Delta B$ und damit einen geringeren Spannungsabfall über die Spule hervor. Aus Fig. 3 geht hervor, dass dieser Effekt mit stärkeren Magnetfeldern des weiteren Bedienabschnitts 22 zunimmt. So nimmt die über die Spule 8 abfallende elektrische Spannung mit zunehmender Magnetfeldstärke des weiteren Bedienabschnitts 22 immer weiter ab bis zu einer Feldstärke, bei welcher der Spulenkern 9 in Sättigung gerät. Ab diesem Punkt sollte eine weitere Zunahme des Magnetfeldes des weiteren Bedienabschnitts 22 keinen weiteren Spannungsabfall zur Folge haben. Damit der Schwingkreis 6 nach dem Einwirken des Magnetfeldes vom weiteren Bedienabschnitt 22 wieder in einen Ausgangszustand X zurückkehren kann, muss die durch die Spule 8 erzeugte magnetische Feldstärke die magnetische Koerzitivfeldstärke $H_C$ übersteigen. Der Spulenkern 9 ist daher für möglichst kleine Koerzitivfeldstärken ausgelegt.

In Fig. 3 ist exemplarisch dargestellt, wie anhand der verschiedenen Hysterese- bzw. Dämpfungskurven $B_I$ bis $B_{VII}$ verschiedene Differenzen der magnetischen Flussdichte $\Delta B_I$ bis $\Delta B_{VIII}$ und entsprechende Differenzen magnetischer Feldstärken $\Delta H_I$ bis $\Delta H_{III}$ zur Unterscheidung verschiedener Zustände Y, Z vom Ausgangszustand X voneinander unterschieden und somit beim Wechsel zwischen den Zuständen X, Y, Z und/oder Verbleib im jeweiligen Zustand X, Y, Z eine Betriebsart der Sensorvorrichtung 1, 1' gewechselt bzw. eingenommen werden kann. So können die Differenzen $\Delta B_{III}/\Delta H_{III}$ beispielsweise den Betriebszustand Y zugeordnet werden. Die Differenzen $\Delta B_{II}/\Delta H_{II}$ können dem weiteren Betriebszustand Z zugeordnet werden. Darüber hinaus ist es möglich, zusätzliche Betriebszustände zu definieren, wozu beispielsweise die Differenzen $\Delta B_I/\Delta H_I$ benutzt werden können. Als Ausgangszustand X kann beispielsweise der Zustand $H_C$ genutzt werden.

Im Rahmen des Erfindungsgedankens sind Abweichungen von den oben beschriebenen Ausführungsformen möglich. So kann eine erfindungsgemäße Anordnung 1, 1' erfindungsgemäße Sensorvorrichtung 2, 2' und Bedienwerkzeuge 20 in beliebiger Anzahl, Form und Ausgestaltung umfassen. Die Sensorvorrichtung 2, 2' kann Gehäuse 3, Schaltungen 4, Leiterplatten 5, Schwingkreise 6, Auswerteeinheiten 7, Spulen 8, Spulenkerne 9, elektromagnetische Felder 10, Signalgeber 11, Leiter 12, Anzeigeelemente 13 und Schaltzonen 14 in beliebiger Anzahl, Ausgestaltung und Verschaltung umfassen, um die jeweiligen Anforderungen zu erfüllen. Entsprechend kann ein erfindungsgemäßes Bedienwerkzeug 20 Bedienabschnitte 21 und weitere Bedienabschnitte 22 in beliebiger Form und Anzahl aufweisen, um damit eine erfindungsgemäße Sensorvorrichtung 2, 2' bedienen zu können, die selbstverständlich auch mit anderen dazu geeigneten Werkzeugen bedient werden kann.

**Patentansprüche**

1. Sensorvorrichtung (2, 2'), insbesondere optische Sensorvorrichtung zur Objektwahrnehmung, mit einer elektrischen Schaltung (4), die wenigstens einen elektrischen Schwingkreis (6) und eine Auswerteeinheit (7) umfasst, die ausgestaltet ist, einen Ausgangszustand (X) und einen gedämpften Zustand (Y) des Schwingkreises (6) zu unterscheiden, wobei dem Wechsel zwischen Ausgangszustand (X) und dem gedämpften Zustand (Y) ein Wechsel einer Betriebsart der Sensorvorrichtung (2, 2') zugeordnet ist, **dadurch gekennzeichnet, dass** die Auswerteeinheit (7) ausgestaltet ist, einen weiteren gedämpften Zustand (Z) vom gedämpften Zustand (Y) zu unterscheiden, wobei dem Wechsel zum weiteren gedämpften Zustand (Z) eine weitere Betriebsart der Sensorvorrichtung (2, 2') zugeordnet ist.

2. Sensorvorrichtung (2, 2') nach Anspruch 1, **dadurch gekennzeichnet, dass** ein Spulenkern (9) einer elektrischen Spule (8) des Schwingkreises (6) sich im weiteren gedämpften Zustand (Z) in magnetischer Sättigung befindet.

3. Sensorvorrichtung (2, 2') nach Anspruch 1 oder 2, **dadurch gekennzeichnet, dass** die Sensorvorrichtung (2, 2') eine mit einem Bedienwerkzeug (20) zugängliche Schaltzone (14) aufweist, und dass der Schwingkreis (6) zumindest abschnittsweise lageveränderlich zur Schaltzone (14) ausgestaltet ist.

4. Sensorvorrichtung (2, 2') nach wenigstens einem der Ansprüche 1 bis 3, **dadurch gekennzeichnet, dass** die Sensorvorrichtung (2, 2') sich in wenigstens einer Betriebsart in einem Empfangsmodus zum Empfangen eines Datenstromes befindet.

5. Sensorvorrichtung (2, 2') nach wenigstens einem der Ansprüche 1 bis 4, **dadurch gekennzeichnet, dass** die Schaltung (4) zum Empfangen eines Datenstromes durch Bedämpfungsänderungen des Schwingkreises (6) ausgestaltet ist.

6. Sensorvorrichtung (2, 2') nach wenigstens einem der Ansprüche 1 bis 5, **dadurch gekennzeichnet, dass** die Schaltung (4) mit einer Datenspeichereinrichtung verbunden ist.

7. Anordnung (1) umfassend eine Sensorvorrichtung (2, 2') nach wenigstens einem der Ansprüche 1 bis 6 und ein Bedienwerkzeug (20) welches einen ersten Bedienabschnitt (21) und wenigstens einen weiteren Bedienabschnitt (22) aufweist, wobei sich die magnetischen Eigenschaften der Bedienabschnitte (21, 22) voneinander unterscheiden.

8. Anordnung (1) nach Anspruch 7, **dadurch gekennzeichnet, dass** der erste Bedienabschnitt (21) ferromagnetisch und der wenigstens eine weitere Bedienabschnitt (22) permanent- und/oder elektromagnetisch aktivierbar ausgestaltet ist.

9. Verfahren zum Bedienen einer Sensorvorrichtung (2, 2'), insbesondere zum Zwecke der Objektwahrnehmung, wobei ein elektrischer Schwingkreis (6) einer Schaltung (4) der Sensorvorrichtung (2, 2') von einem Ausgangszustand (X) in einen gedämpften Zustand (Y) überführt wird, wobei mit einer Auswerteeinheit (7) der Schaltung (4) der Ausgangszustand (X) vom gedämpften Zustand (Y) unterschieden wird, und wobei bei einem Wechsel zwischen Ausgangszustand (X) und gedämpften Zustand (Y) eine Betriebsart der Sensorvorrichtung (2, 2') geändert wird, **dadurch gekennzeichnet, dass** der Schwingkreis (6) in einen weiteren gedämpften Zustand (Z) gebracht wird, dass mit der Auswerteeinheit der weitere gedämpfte Zustand (Z) vom gedämpften Zustand (Y) unterschieden wird, und dass beim Wechsel vom und/oder zum weiteren gedämpften Zustand (Z) die Betriebsart der Sensorvorrichtung (2, 2') geändert wird.

10. Verfahren nach Anspruch 9, **dadurch gekennzeichnet, dass** zum Wechsel der Betriebsart jeweils ein Umschaltpunkt in einer Dämpfungskurve ($B_I$-$B_{VII}$) des Schwingkreises (6) über- und/oder unterschritten wird.

11. Verfahren nach Anspruch 9 oder 10, **dadurch gekennzeichnet, dass** ein Spulenkern (9) einer elektrischen Spule (8) des Schwingkreises (6) zur Erreichung des weiteren gedämpften Zustandes (Z) in magnetische Sättigung gebracht wird.

12. Verfahren nach einem der Ansprüche 9 bis 11, **dadurch gekennzeichnet, dass** durch Wechsel zwischen Ausgangszustand (X) und gedämpften Zustand (Y), zwischen Ausgangszustand (X) und weiterem gedämpften Zustand (Z) und/oder zwischen gedämpften Zustand (Y) und weiterem gedämpften Zustand (Z) die Sensorvorrichtung (2, 2') in einen Empfangsmodus zum Empfangen eines Datenstromes versetzt wird.

13. Verfahren nach einem der Ansprüche 9 bis 12, **dadurch gekennzeichnet, dass** über den Schwingkreis (6) ein Datenstrom auf die und/oder von der Sensorvorrichtung (2, 2') übertragen wird.

14. Verfahren nach einem der Ansprüche 9 bis 13, **dadurch gekennzeichnet, dass** die Sensorvorrichtung (2, 2') mit einem Bedienwerkzeug (20) nach Anspruch 7 oder 8 bedient wird.

**Claims**

1. Sensor device (2, 2'), in particular an optical sensor device for object perception, with an electric circuit (4) comprising at least one electrical oscillating circuit (6) and an evaluation unit (7) designed to distinguish an output state (X) from a muted state (Y) of the oscillating circuit (6), whereby a change in the operating mode of the sensor device (2, 2') is assigned to the change between the output state (X) and the muted state (Y), **characterized in that** the evaluation unit (7) is designed to distinguish a further muted state (Z) from the muted state (Y), whereby a further operating mode of the sensor device (2, 2') is assigned to the change to the further muted state (Z).

2. Sensor device (2, 2') in accordance with Claim 1, **characterized in that** a coil core (9) of an electrical coil (8) of the oscillating circuit (6) is in magnetic saturation in the further muted state (Z).

3. Sensor device (2, 2') in accordance with Claim 1 or 2, **characterized in that** the sensor device (2, 2') has a switching zone (14) accessible with an operating tool (20), and that the oscillating circuit (6) is designed to change its position in relation to the switching zone (14), at least in sections.

4. Sensor device (2, 2') in accordance with at least one of the Claims 1 to 3, **characterized in that,** in at least one mode, the sensor device (2, 2') is in a reception mode for receiving a data stream.

5. Sensor device (2, 2') in accordance with at least one of the Claims 1 to 4, **characterized in that** the circuit (4) is designed to receive a data stream through muting changes in the oscillating circuit (6).

6. Sensor device (2, 2') in accordance with at least one of the Claims 1 to 5, **characterized in that** the circuit (4) is connected to a data storage device.

7. Arrangement (1) comprising a sensor device (2, 2') in accordance with at least one of the Claims 1 to 6 and an operating tool (20) which has a first operating section (21) and at least one further operating section (22), whereby the magnetic properties of the operating sections (21, 22) differ from each other.

8. Arrangement (1) in accordance with Claim 7, **characterized in that** the first operating section (21) is designed so that it can be ferro-magnetically activated, and the at least one further operating section (22) is designed so that it can be permanently and/or electromagnetically activated.

9. Process for operating a sensor device (2, 2'), in particular for the purpose of object detection, whereby an electrical oscillating circuit (6) of a circuit (4) of the sensor device (2, 2') is switched from an output state (X) to a muted state (Y), whereby the output state (X) is distinguished from the muted state (Y) with an evaluation unit (7) of the circuit (4), and whereby an operating mode of the sensor device (2, 2') is changed in the event of a change between the output state (X) and the muted state (Y), **characterized in that** the oscillating circuit (6) is switched to a further muted state (Z), that the further muted state (Z) is distinguished from the muted state (Y) with the evaluation unit, and that the operating mode of the sensor device (2, 2') is changed in the event of a change from and/or to the further muted state (Z).

10. Process in accordance with Claim 9, **characterized in that** to change the operating mode, a switchover point in a muting curve ($B_I$-$B_{VII}$) of the oscillating circuit (6) is exceeded and/or undershot.

11. Process in accordance with Claim 9 or 10, **characterized in that** a coil core (9) of an electrical coil (8) of the oscillating circuit (6) is brought to magnetic saturation in order to achieve the further muted state (Z).

12. Process in accordance with one of the Claims 9 to 11, **characterized in that,** by changing between the output state (X) and the muted state (Y), between the output state (X) and the further muted state (Z) and/or between the muted state (Y) and the further muted state (Z), the sensor device (2, 2') is set to a reception mode for receiving a data stream.

13. Process in accordance with one of the Claims 9 to 12, **characterized in that** a data stream is transmitted to and/or from the sensor device (2, 2') via the oscillating circuit (6).

14. Process in accordance with one of the Claims 9 to 13, **characterized in that** the sensor device (2, 2') is operated with an operating tool (20) in accordance with Claim 7 or 8.

## Revendications

1. Dispositif de capteur (2, 2'), en particulier dispositif de capteur optique pour la perception d'objets, doté d'un circuit électrique (4), comprenant au moins un circuit oscillant électrique (6) et une unité d'évaluation (7), conçue pour distinguer un état de sortie (X) et un état atténué (Y) du circuit oscillant (6), un changement de mode de fonctionnement du dispositif de capteur (2, 2') étant attribué au passage de l'état de sortie (X) à l'état atténué (Y), **caractérisé en ce que** l'unité d'évaluation (7) est conçue pour distinguer un autre état atténué (Z) de l'état atténué (Y), un autre mode de fonctionnement du dispositif de capteur (2, 2') étant attribué au passage à l'autre état atténué (Z).

2. Dispositif de capteur (2, 2') selon la revendication 1, **caractérisé en ce qu'un** noyau de bobine (9) d'une bobine électrique (8) du circuit oscillant (6) se trouve dans l'autre état atténué (Z) en saturation magnétique.

3. Dispositif de capteur (2, 2') selon la revendication 1 ou 2, **caractérisé en ce que** le dispositif de capteur (2, 2') présente une zone de commutation (14) accessible avec un outil de commande (20), et **en ce que** le circuit oscillant (6) est conçu au moins par sections dans des positions variables par rapport à la zone de commutation (14).

4. Dispositif de capteur (2, 2') selon au moins une des revendications 1 à 3, **caractérisé en ce que** le dispositif de capteur (2, 2') se trouve dans au moins un mode de fonctionnement dans un mode de réception pour la réception d'un flux de données.

5. Dispositif de capteur (2, 2') selon au moins une des revendications 1 à 4, **caractérisé en ce que** le circuit (4) est conçu pour la réception d'un flux de données par des changements d'excitation du circuit oscillant (6).

6. Dispositif de capteur (2, 2') selon au moins une des revendications 1 à 5, **caractérisé en ce que** le circuit(4) est raccordé à un dispositif de stockage de données.

7. Agencement (1) comprenant un dispositif de capteur (2, 2') selon au moins une des revendications 1 à 6 et un outil de commande (20) qui présente une première section de commande (21) et au moins une autre section de commande (22), les propriétés magnétiques des sections de commande (21, 22) se distinguant les unes des autres.

8. Agencement (1) selon la revendication 7, **caractérisé en ce que** la première section de commande (21) est activable de manière ferromagnétique et la au moins une autre section de commande (22) est activable de manière permanente et/ou électromagnétique.

9. Procédé d'utilisation d'un dispositif de capteur (2, 2'), destiné en particulier à la perception d'objets, un circuit oscillant électrique (6) d'un circuit (4) du dispositif de capteur (2, 2') étant passé d'un état de sortie (X) à un état atténué (Y), une unité d'évaluation (7) du circuit (4) permettant de distinguer l'état de sortie (X) de l'état atténué (Y), et en cas de changement entre l'état de sortie (X) et l'état atténué (Y) un mode de fonctionnement du dispositif de capteur (2, 2') étant modifié, **caractérisé en ce que** le circuit oscillant (6) est mis dans un autre état atténué (Z), **en ce que** l'unité d'évaluation permet de distinguer l'autre état atténué (Z) de l'état atténué (Y), et **en ce qu'**en cas de changement de et/ou vers l'autre état atténué (Z) le mode de fonctionnement du dispositif de capteur (2, 2') est modifié.

10. Procédé selon la revendication 9, **caractérisé en ce que,** pour le changement de mode de fonctionnement, un point de commutation n'est pas atteint et/ou est dépassé dans une courbe d'atténuation ($B_I$-$B_{VII}$) du circuit oscillant (6).

11. Procédé selon la revendication 9 ou 10, **caractérisé en ce qu'**un noyau de bobine (9) d'une bobine électrique (8) du circuit oscillant (6) est amené à atteindre l'autre état atténué (Z) en saturation magnétique.

12. Procédé selon l'une des revendications 9 à 11, **caractérisé en ce que** le dispositif de capteur (2, 2') est déplacé dans un mode de réception pour la réception d'un flux de données par le changement entre état de sortie (X) et état atténué (Y), entre état de sortie (X) et autre état atténué (Z) et/ou entre état atténué (Y) et autre état atténué (Z).

13. Procédé selon l'une des revendications 9 à 12, **caractérisé en ce qu'**un flux de données est transmis au et/ou depuis le dispositif de capteur (2, 2') via le circuit oscillant (6).

14. Procédé selon l'une des revendications 9 à 13, **caractérisé en ce que** le dispositif de capteur (2, 2') est utilisé avec un outil de commande (20) selon la revendication 7 ou 8.

Fig. 1

Fig. 2

Fig. 3

**IN DER BESCHREIBUNG AUFGEFÜHRTE DOKUMENTE**

**In der Beschreibung aufgeführte Patentdokumente**

- DE 1175327 B
- DE 102006032226 A1